(19)

**Europäisches Patentamt**

**European Patent Office**

**Office européen des brevets**

(11) **EP 3 593 154 B1**

(12) **FASCICULE DE BREVET EUROPEEN**

(45) Date de publication et mention de la délivrance du brevet:
**08.09.2021 Bulletin 2021/36**

(21) Numéro de dépôt: **18709281.2**

(22) Date de dépôt: **21.02.2018**

(51) Int Cl.:
**G01R 31/34** *(2020.01)*   **G01R 31/00** *(2006.01)*

(86) Numéro de dépôt international:
**PCT/EP2018/054319**

(87) Numéro de publication internationale:
**WO 2018/162240 (13.09.2018 Gazette 2018/37)**

(54) **PROCEDE DE SURVEILLANCE D'UN EQUIPEMENT DE TYPE ACTIONNEUR ELECTROMECANIQUE**

VERFAHREN ZUR ÜBERWACHUNG EINER ELEKTROMAGNETISCHEN VORRICHTUNG VOM AKTUATORTYP

METHOD FOR MONITORING AN ELECTROMAGNETIC ACTUATOR TYPE APPARATUS

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **06.03.2017 FR 1751812**

(43) Date de publication de la demande:
**15.01.2020 Bulletin 2020/03**

(73) Titulaires:
• **Safran Electronics & Defense**
  **75015 Paris (FR)**
• **Centre National de la Recherche Scientifique**
  **75016 Paris (FR)**

(72) Inventeurs:
• **BREUNEVAL, Romain**
  **75015 Paris (FR)**
• **MANSOURI, Badr**
  **75015 Paris (FR)**
• **BOUTLEUX, Emmanuel**
  **75015 Paris (FR)**
• **CLERC, Guy**
  **75015 Paris (FR)**
• **HUILLERY, Julien**
  **75015 Paris (FR)**
• **MICHAUD, Ryan**
  **75015 Paris (FR)**

(74) Mandataire: **Lavaud, Thomas et al**
  **Cabinet Boettcher**
  **16, rue Médéric**
  **75017 Paris (FR)**

(56) Documents cités:
  **US-A1- 2015 293 177    US-A1- 2016 282 416**

• **DIONYSIOS V SPYROPOULOS ET AL: "Induction motor stator fault diagnosis technique using Park vector approach and complex wavelets", ELECTRICAL MACHINES (ICEM), 2012 XXTH INTERNATIONAL CONFERENCE ON, IEEE, 2 septembre 2012 (2012-09-02), pages 1730-1734, XP032464949, DOI: 10.1109/ICELMACH.2012.6350114 ISBN: 978-1-4673-0143-5**
• **IOANNIS TSOUMAS ET AL: "Empirical Mode Decomposition of the stator start-up current for rotor fault diagnosis in asynchronous machines", ELECTRICAL MACHINES, 2008. ICEM 2008. 18TH INTERNATIONAL CONFERENCE ON, IEEE, PISCATAWAY, NJ, USA, 6 septembre 2008 (2008-09-06), pages 1-6, XP031436205, ISBN: 978-1-4244-1735-3**

**EP 3 593 154 B1**

# EP 3 593 154 B1

**Description**

L'invention concerne le domaine des procédés de surveillance d'un équipement de type actionneur électromécanique.

ARRIERE PLAN DE L'INVENTION

Les fonctions de health monitoring (on parle aussi, mais moins fréquemment, de maintenance conditionnelle, de maintenance prédictive ou de maintenance prévisionnelle) sont utilisées pour anticiper la dégradation d'un équipement ou d'un système, notamment dans le domaine aéronautique.

Les fonctions de *health monitoring* permettent ainsi d'éviter une panne, d'optimiser la durée de vie, d'anticiper et de planifier les opérations de maintenance (et d'une éventuelle dépose), et donc de réduire les coûts des opérations de maintenance de l'équipement ou du système.

La mise en œuvre d'une fonction de *health monitoring* comporte classiquement une phase d'acquisition de données, une phase de pré-conditionnement des données, une phase d'extraction de signatures, une phase de diagnostic et une phase de pronostic.

La phase d'acquisition de données consiste à acquérir des données de mesure produites par des capteurs mesurant des paramètres représentatifs d'une performance de l'équipement ou du système.

L'acquisition des données est par exemple réalisée via des essais, ou bien par téléchargement sur l'équipement ou sur le système lorsque celui-ci est opérationnel.

La phase de pré-conditionnement des données consiste notamment à filtrer les données pour supprimer le bruit de mesure présent dans les données.

La phase d'extraction de signatures consiste à traiter les données pour en extraire des signatures représentatives de l'état de l'équipement ou du système et, éventuellement, d'une dégradation du fonctionnement de l'équipement ou du système. Une telle dégradation est causée par la présence d'un ou de plusieurs défauts subis par l'équipement ou par le système. Les signatures sont donc représentatives du ou des défauts.

La phase de diagnostic consiste notamment à évaluer les signatures pour estimer l'état de l'équipement ou du système et, en cas de défaut, pour localiser et évaluer la sévérité dudit défaut.

La phase de pronostic consiste à estimer la durée de vie restante de l'équipement ou du système.

Le document US 2015/293177 A1 (OTTEWILL JAMES ET AL) décrit un procédé de diagnostic de l'état de systèmes électromécaniques dans lesquels une machinerie électrique rotative est utilisée, le procédé de diagnostic étant basé sur l'analyse de l'impédance estimée à partir d'au moins deux courants et deux tensions, les courants et les tensions étant mesurés lors du fonctionnement des systèmes électromécaniques.

OBJET DE L'INVENTION

L'invention a pour objet d'améliorer la sensibilité des signatures aux défauts d'un équipement ou d'un système, et donc d'améliorer la détection et l'évaluation de la sévérité desdits défauts.

RESUME DE L'INVENTION

En vue de la réalisation de ce but, on propose un procédé de surveillance d'un équipement de type actionneur électromécanique, l'équipement comportant un moteur électrique triphasé, le procédé de surveillances comprenant les étapes :

- de réaliser des mesures de courants triphasés qui alimentent le moteur électrique triphasé ;
- de projeter dans un repère de Park les mesures de courants triphasés, pour obtenir un courant en quadrature ;
- de mettre en œuvre, sur le courant en quadrature, une méthode de décomposition modale empirique ensembliste couplée à une méthode de séparation aveugle de source, pour obtenir des composantes sources ;
- de sélectionner automatiquement parmi les composantes sources, un premier ensemble de composantes sources sensibles à un premier défaut et un deuxième ensemble de composantes sources sensibles à un deuxième défaut en utilisant un critère de sélection, le premier défaut et le deuxième défaut étant susceptibles de dégrader le fonctionnement de l'équipement ;
- de construire un premier signal virtuel de défaut à partir du premier ensemble de composantes sources et un deuxième signal virtuel de défaut à partir du deuxième ensemble de composantes sources ;
- d'extraire du premier signal virtuel de défaut un premier ensemble de signatures représentatives du premier défaut, et du deuxième signal virtuel de défaut un deuxième ensemble de signatures représentatives du deuxième défaut.

Le procédé de surveillance selon l'invention améliore la sensibilité des signatures du premier ensemble de signatures au premier défaut et des signatures du deuxième ensemble de signatures au deuxième défaut, et améliore la détection du premier défaut et du deuxième défaut. Lorsque la sévérité du premier défaut et la sévérité du deuxième défaut sont en outre calculées, le procédé de surveillance selon l'invention améliore aussi l'évaluation de ces sévérités.

L'invention sera mieux comprise à la lumière de la description qui suit d'un mode de mise en œuvre particulier non limitatif de l'invention.

BREVE DESCRIPTION DES DESSINS

Il sera fait référence aux dessins annexés, parmi lesquels :

- les figures 1 à 4 représentent des étapes successives du procédé de surveillance selon l'invention ;
- la figure 5 représente une étape de mise en œuvre d'une méthode de séparation aveugle de source du procédé de surveillance selon l'invention ;
- la figure 6 représente une étape de calcul de sévérité du procédé de surveillance selon l'invention.

DESCRIPTION DETAILLEE DE L'INVENTION

Le procédé de surveillance selon l'invention est ici mis en œuvre sur un actionneur électromécanique linéaire de commande de vol d'un aéronef.

L'actionneur électromécanique linéaire comporte ici un moteur électrique de type moteur synchrone triphasé à aimants permanents, une transmission mécanique qui peut être en prise directe ou indirecte, un module électronique de puissance qui peut être déporté ou non, un module électronique de commande qui peut être déporté ou non, et un ensemble de capteurs. L'ensemble de capteurs comprend ici des capteurs de courant, une sonde de température, un capteur d'effort et un capteur de position. Le capteur de position mesure une position angulaire du rotor du moteur électrique.

Le procédé de surveillance selon l'invention permet de réaliser une fonction de *health monitoring* sur l'actionneur électromécanique linéaire.

Comme cela a été dit plus tôt, la fonction de health *monitoring* comporte une phase d'acquisition de données, une phase de pré-conditionnement des données, une phase d'extraction de signatures, une phase de diagnostic et une phase de pronostic.

Le procédé de surveillance selon l'invention comporte huit étapes successives mises en œuvre au cours de la phase de pré-conditionnement des données et de la phase d'extraction de signatures.

A titre d'exemple, le procédé de surveillance selon l'invention vise à améliorer la détection et l'évaluation de deux défauts susceptibles de dégrader le fonctionnement de l'actionneur électromécanique linéaire : un premier défaut $def_A$ de court-circuit du stator du moteur électrique, et un deuxième défaut $def_B$ de grippage de la transmission mécanique.

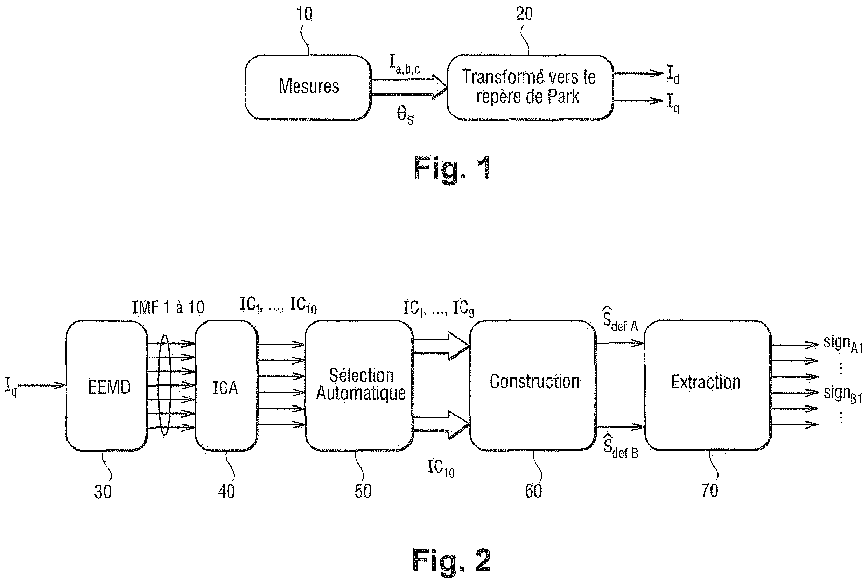

En référence aux figures 1 à 4, le procédé de surveillance selon l'invention comporte tout d'abord une étape de mesure 10 consistant à réaliser des mesures synchronisées des courants triphasés $I_{a,b,c}$ (a, b et c sont les phases du moteur électrique) qui alimentent le moteur électrique, et de la position angulaire $\theta_s$ du rotor du moteur électrique.

Le procédé de surveillance selon l'invention comporte ensuite une étape de projection 20 dans le repère de Park (repère lié au rotor et dont l'axe d est en phase avec le flux d'excitation) des mesures des courants triphasés réalisées au cours de l'étape 10. La transformation de Park est réalisée en utilisant l'équation suivante :

$$\begin{bmatrix} I_d \\ I_q \end{bmatrix} = \sqrt{\frac{2}{3}} \begin{bmatrix} \cos(\theta_s) & \cos\left(-\frac{2\pi}{3} + \theta_s\right) & \cos\left(+\frac{2\pi}{3} + \theta_s\right) \\ -\sin(\theta_s) & -\sin\left(-\frac{2\pi}{3} + \theta_s\right) & -\sin\left(+\frac{2\pi}{3} + \theta_s\right) \end{bmatrix} \begin{bmatrix} I_a \\ I_b \\ I_c \end{bmatrix}$$

Dans cette équation, $I_a$, $I_b$ et $I_c$ sont les courants triphasés qui alimentent le moteur électrique, $I_d$ est le courant direct dans le repère de Park, $I_q$ est le courant en quadrature dans le repère de Park, et $\theta_s$ est la position angulaire électrique du champ tournant du stator du moteur électrique.

On a :

$\theta_s$=npp*position angulaire mécanique du rotor,
où npp est le nombre de paires de pôles du moteur.

On remarque que, sur la figure 1 (et sur les autres figures), la flèche étroite correspond à un signal monovoie alors que les flèches larges correspondent chacune à un signal multivoies.

Le procédé de surveillance selon l'invention comporte ensuite une étape de mise en œuvre d'une décomposition modale empirique ensembliste 30 (généralement désignée par EEMD, pour *Ensemblist Empirical Mode Decomposition*). La décomposition modale empirique ensembliste est appliquée sur le courant en quadrature $I_q$.

La mise en œuvre de la décomposition modale empirique ensembliste 30 utilise la mise en œuvre d'une décomposition modale empirique (généralement désignée par EMD).

La décomposition modale empirique vise à décomposer un signal quelconque en une série de composantes oscillatoires IMF (pour *Intrinsic Mode Function)*.

Chaque composante oscillatoire IMF est représentative de phénomènes sur une gamme de fréquences.

Un signal quelconque y est décomposé par une décomposition modale empirique de la manière suivante :

$$y = \sum_{j=1}^{n} \mathrm{IMF}_j + r.$$

Les $IMF_j$ sont les composantes oscillatoires IMF.

Le signal r est un signal résiduel duquel il n'est plus possible d'extraire des composantes oscillatoires IMF.

Un exemple d'algorithme EMD, qui permet d'obtenir les composantes oscillatoires IMF, est donné ci-dessous.

| Etape | Entrées | Sorties | Tâches |
|---|---|---|---|
| Init | $y$ | $r_1$ | Poser $r_1 = y$ |
| 1 | $r_j$ | $R_{min}$ ; $R_{max}$ | Déterminer les minima locaux $R_{min} = min_l[r_j]$ et maximums locaux $R_{max} = max_l[r_j]$ |
| 2 | $R_{min}$ ; $R_{max}$ | $e_{inf}$ ; $e_{sup}$ | Relier les minima (respectivement les maxima) entre eux par une spline cubique pour former l'enveloppe inférieure (respectivement supérieure) |
| 3 | $e_{inf}$ ; $e_{sup}$ ; $r_j$ | $h_j$ ; $ImF_j$ $r_{j+1}$ | Calculer $h_j = r_j - moy(e_{sup}$ ; $e_{inf})$<br>Poser $IMF_j = h_j$<br>Calculer $r_{j+1} = r_j - IMF_j$ |
| 4 | | | Répéter étapes 1 à 3 jusqu'à atteindre le critère d'arrêt |
| Arrêt | $r_j$ | | $r_j$ monotone $\Leftrightarrow$ $e_{sup}$ et $e_{inf}$ symétriques $\Leftrightarrow$ $moy(e_{sup}$ ; $e_{inf}) = 0$ |

On parle de « tamisage » pour évoquer ce type d'algorithme.

Les premières composantes oscillatoires IMF extraites sont les composantes oscillatoires IMF du signal *y* à haute fréquence, et les dernières composantes oscillatoires IMF extraites sont les composantes oscillatoires IMF du signal *y* à basse fréquence.

La mise en œuvre de la décomposition modale empirique ensembliste 30 consiste à effectuer un certain nombre de fois la décomposition modale empirique sur des réalisations bruitées d'un signal, puis à moyenner les composantes oscillatoires IMF générées. On obtient des composantes oscillatoires IMF « vraies ».

On utilise ainsi un algorithme EEMD, dont un exemple est donné ci-dessous.

| Etape | Entrées | Sorties | Tâches |
|---|---|---|---|
| Init | $y, N$ | $r_0$ | Poser $r_0 = y$ et $N_{iter} = N$ (choix utilisateur) |
| 1 | $r_0$; $\theta$ | $r_{1;wj}$ | Poser $r_{1;wj} = r_0 + w(\theta)$ où $w(\theta)$ : bruit blanc (aléatoire) de paramètres $\theta$ connus |
| 2 | $r_{1;wj}$ | $IMF_{1-j}$ | Effectuer une EMD sur $r_{1;wj}$ |
| 3 | | | Répéter 1 et 2 jusqu'à $j = N$ |

(suite)

| Etape | Entrées | Sorties | Tâches |
|-------|---------|---------|--------|
| 4 : Final | $IMF_{1\text{-}j}$ | $IMF_j$ | Calculer les IMF du signal en moyennant les IMF pour chaue réalisation de bruits $$IMF_j = \left(\frac{1}{N_{iter}}\right) \sum_{i=1}^{N_{iter}} IMF_{1-i}$$ |

L'utilisation de la décomposition modale empirique ensembliste 30 permet d'éviter un « mélange des modes », c'est à dire une superposition de signaux à haute fréquence sur un signal à basse fréquence, pour une composante oscillatoire IMF donnée.

Le procédé de surveillance selon l'invention comporte ensuite une étape de mise en œuvre d'une méthode de séparation aveugle de source (SAS), qui permet, à partir d'observations, d'estimer un ensemble de sources inconnues. La méthode de séparation aveugle de source utilisée est ici une analyse en composantes indépendantes 40 (générale-lement désignée par ICA, pour *Independent Component Analysis*) . L'analyse en composantes indépendantes 40 utilise comme critère de séparation le critère de l'indépendance statistique.

Comme on le verra plus tard, les sources dont il est ici question sont des signaux représentatifs des défauts subis par l'actionneur électromécanique linéaire, c'est à dire le premier défaut $def_A$ (court-circuit du stator du moteur électrique) et le deuxième défaut $def_B$ (grippage de la transmission mécanique).

L'analyse en composantes indépendantes 40 est mise en œuvre sur les composantes oscillatoires IMF vraies (IMF 1 à 10 sur les figures 2, 4, 5), qui constituent des observations « virtuelles » qui vont fournir les entrées de l'analyse en composantes indépendantes 40.

On couple ainsi l'analyse en composantes indépendantes 40 et la décomposition modale empirique ensembliste 30.

Le principe général de l'analyse en composantes indépendantes 40 est d'estimer un ensemble de sources $\hat{s}$ à partir d'un ensemble d'observations x en définissant une matrice de séparation W telle que $\hat{s} = Wx$, en minimisant un critère de séparation $\Phi$ (qui est ici le critère de l'indépendance statistique). L'ensemble de sources $\hat{s}$ comprend ici un vecteur de composantes indépendantes de source $IC_1$, $IC_2$, $IC_3$, ..., $IC_n$.

Le couplage se traduit par la relation suivante :

$$\begin{bmatrix} IC_1 \\ IC_2 \\ \dots \\ IC_n \end{bmatrix} = \begin{bmatrix} W_{11} & W_{12} & \dots & W_{1n} \\ W_{21} & W_{22} & \dots & W_{2n} \\ \vdots & \vdots & \vdots & \vdots \\ W_{n1} & W_{n2} & \dots & W_{nn} \end{bmatrix} \begin{bmatrix} IMF_1 \\ IMF_2 \\ \dots \\ IMF_n \end{bmatrix}.$$

L'intérêt de coupler la décomposition modale empirique ensembliste 30 et l'analyse en composantes indépendantes 40 est d'obtenir des signaux beaucoup plus sensibles au premier défaut $def_A$ et au deuxième défaut $def_B$ subis par l'actionneur électromécanique linéaire, par rapport à un cas où la décomposition modale empirique ensembliste 30 et l'analyse en composantes indépendantes 40 seraient utilisées seules et séparément. Le couplage produit des signaux qui sont typiquement 10 à 20 fois plus sensibles au premier défaut $def_A$ et au deuxième défaut $def_B$.

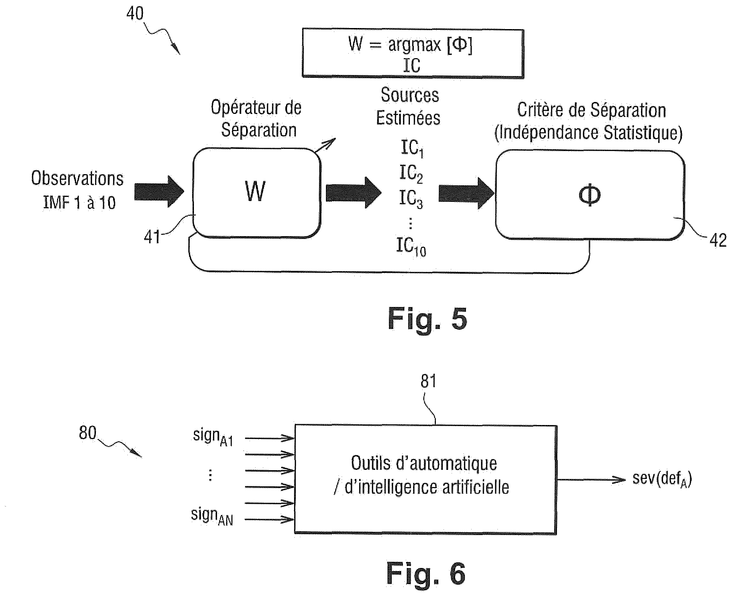

En référence à la figure 5, l'analyse en composantes indépendantes 40 est réalisée de la manière suivante.

Les observations virtuelles, c'est à dire les composantes oscillatoires IMF vraies (IMF 1 à 10) sont acquises.

Un algorithme ICA est mis en œuvre.

La matrice de séparation W est définie (étape 41).

La matrice de séparation W peut être composée de coefficients $W_{ij}$ scalaires. On parle alors d'un cas « instantané ». La matrice de séparation W peut aussi être composée de filtres à réponse impulsionnelle finie (ou FIR, pour *Finite Impulse Response Filter*). On parle alors d'un cas « convolutif ». Pour le cas convolutif, l'ordre des filtres doit être connu a priori et donc défini préalablement à la mise en œuvre de l'analyse en composantes indépendantes.

L'algorithme ICA vise à résoudre le problème suivant :

$$W = \operatorname{argmax}_{IC}[\Phi].$$

Les composantes indépendantes de source $IC_1$, $IC_2$, $IC_3$, ..., $IC_{10}$ sont alors estimées selon un processus itératif.

Le critère de l'indépendance statistique est réévalué à chaque itération, et la matrice de séparation W est redéfinie.

Le procédé de surveillance selon l'invention comporte ensuite une étape de sélection automatique 50 des composantes indépendantes de source $IC_1$, $IC_2$, $IC_3$, ..., $IC_{10}$.

La sélection automatique 50 a pour but de sélectionner les composantes indépendantes de source $IC_1$, $IC_2$, $IC_3$, ..., $IC_{10}$ pour distinguer les composantes indépendantes de source $IC_1$, $IC_2$, $IC_3$, ..., $IC_{10}$ les plus représentatives du premier défaut $def_A$, et les composantes indépendantes de source $IC_1$, $IC_2$, $IC_3$, ..., $IC_{10}$ les plus représentatives du deuxième défaut $def_B$.

La sélection des composantes indépendantes de source $IC_1$, $IC_2$, $IC_3$, ..., $IC_{10}$ est réalisée selon un critère de sélection.

Le critère de sélection peut être basé sur différentes caractéristiques statistiques : moyenne, variance, coefficient de dissymétrie, maximum, minimum, valeur efficace, Kurtosis, etc.

Le critère de sélection est choisi par rapport aux défauts considérés, c'est à dire par rapport au premier défaut $def_A$ et au deuxième défaut $def_B$.

Ici, le critère de sélection est basé sur le calcul du Kurtosis, qui est défini par :

$$S_{Kur}(x) = \frac{\sum_{i=1}^{N}(x_i - \bar{x})^4}{N * (\sigma^2)^2},$$

où :

- N est le nombre de points sur l'échantillon ;
- $\bar{X}$ est la moyenne des points sur l'échantillon ;
- $\sigma$ est la variance des points sur l'échantillon.

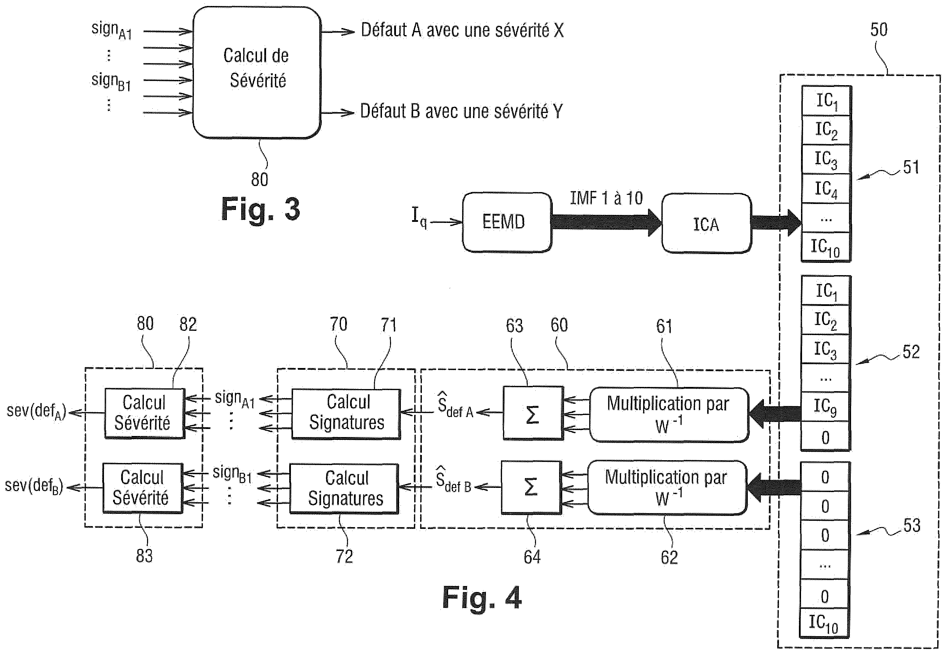

En référence plus particulièrement à la figure 4, la sélection automatique 50 produit donc un ensemble de composantes sources 51, qui comprend les composantes sources $IC_1$, $IC_2$, ..., IC10.

Les composantes sources IC1, IC2, ..., IC10 sont ensuite testées sur le Kurtosis, puis réarrangées.

On obtient ainsi un premier ensemble de composantes sources 52 de faible Kurtosis, qui comprend les composantes sources IC1, IC2, ..., IC9, et un deuxième ensemble de composantes sources 53 de fort Kurtosis, qui comprend la composante source IC10.

Le procédé de surveillance selon l'invention comporte ensuite une étape de construction 60, qui consiste à construire des signaux sources virtuels $\hat{s}_k$ représentatifs des défauts k (k représente donc le premier défaut $def_A$ ou le deuxième défaut $def_B$) .

On a :

$$\hat{s}_k = \sum W^{-1} IC_{select\_k},$$

où les $IC_{select\_k}$ correspondent à la sélection des IC pour le défaut k, c'est-à-dire au premier ensemble de composantes sources 52 (pour le premier défaut $def_A$, $k = A$) et au deuxième ensemble de composantes sources 53 (pour le deuxième défaut $def_B$ , $k = B$) .

L'étape de construction 60 comporte ainsi une multiplication par $W^{-1}$ (étape 61) du premier ensemble 52, et une multiplication par $W^{-1}$ (étape 62) du deuxième ensemble 53.

L'étape de construction 60 comporte ensuite une sommation (étape 63) des composantes obtenues par la multiplication par $W^{-1}$ du premier ensemble 52, et une sommation (étape 64) des composantes obtenues par la multiplication par $W^{-1}$ du deuxième ensemble 53.

On obtient ainsi :

- $\hat{s}_{defA}$, qui est un premier signal virtuel de défaut présentant une sensibilité maximale au premier défaut $def_A$ ;
- $\hat{s}_{defB}$, qui est un deuxième signal virtuel de défaut présentant une sensibilité maximale au deuxième défaut $def_B$.

Le procédé de surveillance selon l'invention comporte ensuite une étape de d'extraction de signatures 70. L'étape d'extraction de signatures 70 consiste à extraire du premier signal virtuel de défaut $\hat{s}_{defA}$ une première signature $sign_A$, et à extraire du deuxième signal virtuel de défaut $\hat{s}_{defB}$ une deuxième signature $sign_B$.

L'extraction de signatures peut se faire selon un premier type de méthodes et un deuxième type de méthodes.

Le premier type de méthodes consiste à calculer des paramètres statistiques « globaux » sur le premier signal

virtuel de défaut $\hat{s}_{defA}$ et sur le deuxième signal virtuel de défaut $\hat{s}_{defB}$. Les paramètres statistiques globaux sont par exemple la moyenne, le maximum, le Kurtosis, le nombre de passage par zéros, etc.

Le deuxième type de méthodes consiste à définir des paramètres combinés résultant d'une combinaison de paramètres globaux entre eux.

On construit ainsi selon le deuxième type de méthodes la signature suivante, à partir du deuxième signal virtuel de défaut $\hat{s}_{defB}$ (grippage) :

- Sign=NbPics*AmpCC, où :
  o NbPics est le nombre de fois où le deuxième signal virtuel de défaut $\hat{s}_{defB}$ passe au-dessus d'un seuil prédéfini sur l'échantillon ;AmpCC est l'amplitude crête à crête maximum entre deux pics du deuxième signal virtuel de défaut $\hat{s}_{defB}$.

D'autres exemples de signatures pour le premier défaut $def_A$ sont par exemple :

- le nombre de passages par zéro. Les passages par zéro ne sont comptabilisés que si l'amplitude du signal est supérieure à un certain seuil $\in_1$ ;

- la valeur efficace, calculée par : $\left(\sum_{t=1}^{T} \hat{s}_{defA}(t)^2\right)^{\frac{1}{2}}$, où T est la longueur du signal, et où t est le temps ;

- l'énergie, calculée par : $\left(\sum_{t=1}^{T} \hat{s}_{defA}(t)^2\right)$.

D'autres exemples de signatures pour le deuxième défaut $def_B$ sont par exemple :

- la valeur efficace, calculée par : $\left(\sum_{t=1}^{T} \hat{s}_{defB}(t)^2\right)^{\frac{1}{2}}$, où T est la longueur du signal, et t est le temps) ;

- l'énergie, calculée par : $\left(\sum_{t=1}^{T} \hat{s}_{defB}(t)^2\right)$.

Le procédé de surveillance selon l'invention peut enfin comporter enfin une étape de calcul de sévérité 80 des défauts.

Le calcul de sévérité peut se faire de plusieurs manières.

On peut ainsi utiliser une métrique sur une signature, par exemple sur la première signature $sign_A$ :

$$sev(def_A) = \frac{|sign_A - sign_{A0}|}{|sign_{A0}|},$$

où

$sign_{A0}$ est la valeur de la première signature pour le premier défaut $def_A$ au début de la mise en service de l'actionneur électromécanique linéaire.

On peut aussi, en référence à la figure 6, appliquer une méthode de traitement 81 qui repose sur des outils de de l'intelligence artificielle (par exemple, une méthode qui utilise des Réseaux de Neurones, une Machines à Vecteurs de Supports, des Réseaux Bayésiens).

On applique la méthode de traitement 81 sur plusieurs signatures $sign_{A0}$, ..., $sign_{AN}$ pour obtenir la sévérité $sev(def_A)$.

On estime ainsi la sévérité de manière plus précise et plus robuste.

Bien entendu, l'invention n'est pas limitée au mode de réalisation décrit mais englobe toute variante entrant dans le champ de l'invention telle que définie par les revendications.

Bien que l'on ait ici mis en œuvre l'invention sur un actionneur électromécanique linéaire, l'invention s'applique bien sûr à tout autre équipement de type actionneur électromécanique, l'équipement comportant un moteur électrique triphasé.

Bien que l'on se soit ici intéressé au défaut de court-circuit du stator du moteur électrique triphasé et au défaut de grippage de la transmission mécanique, l'invention s'applique bien sûr à des défauts différents, et à un nombre de défauts différents.

Les signatures (et le calcul de sévérité) utilisées ici pour le premier défaut peuvent aussi être utilisées pour le deuxième défaut, et réciproquement.

**Revendications**

1. Procédé de surveillance d'un équipement de type actionneur électromécanique, l'équipement comportant un moteur électrique triphasé, le procédé de surveillances comprenant les étapes :

   - de réaliser des mesures de courants triphasés ($I_{a,b,c}$) qui alimentent le moteur électrique triphasé ;

   le procédé est **caractérisé par** les étapes:

   - de projeter dans un repère de Park les mesures de courants triphasés, pour obtenir un courant en quadrature ($I_q$) ;
   - de mettre en œuvre, sur le courant en quadrature, une méthode de décomposition modale empirique ensembliste (30) couplée à une méthode de séparation aveugle de source (40), pour obtenir des composantes sources (IC1,..., IC10) ;
   - de sélectionner automatiquement (50) parmi les composantes sources un premier ensemble (52) de composantes sources (IC1,..., IC9) sensibles à un premier défaut et un deuxième ensemble (53) de composantes sources (IC10) sensibles à un deuxième défaut en utilisant un critère de sélection, le premier défaut et le deuxième défaut étant susceptibles de dégrader le fonctionnement de l'équipement ;
   - de construire (60) un premier signal virtuel de défaut $\hat{s}_{defA}$ à partir du premier ensemble de composantes sources et un deuxième signal virtuel de défaut $\hat{s}_{defB}$ à partir du deuxième ensemble de composantes sources ;
   - d'extraire (70) du premier signal virtuel de défaut un premier ensemble de signatures représentatives du premier défaut, et du deuxième signal virtuel de défaut un deuxième ensemble de signatures représentatives du deuxième défaut.

2. Procédé de surveillance selon la revendication 1, dans lequel la méthode de séparation aveugle de source est une analyse en composantes indépendantes qui utilise comme critère de séparation un critère d'indépendance statistique.

3. Procédé de surveillance selon la revendication 1, dans lequel la sélection automatique est réalisée selon un critère de sélection choisi par rapport au premier défaut et au deuxième défaut et basé sur une caractéristique statistique du premier ensemble de composantes sources et du deuxième ensemble de composantes sources.

4. Procédé de surveillance selon la revendication 3, dans lequel la caractéristique statistique est un Kurtosis.

5. Procédé de surveillance selon la revendication 1, dans lequel la première signature et/ou la deuxième signature $sign_k$ est telle que $sign_k = NbPics*AmpCC$, où NbPics est un nombre de fois où le premier signal virtuel de défaut ou deuxième signal virtuel de défaut correspondant devient supérieur à un seuil prédéfini, et où AmpCC est une amplitude crête à crête maximale entre deux pics du premier signal virtuel de défaut ou deuxième signal virtuel de défaut correspondant.

6. Procédé de surveillance selon la revendication 1, dans lequel une signature parmi les signatures du premier ensemble de signatures ou du deuxième ensemble de signatures est une valeur efficace calculée par : $\left(\sum_{t=1}^{T} \hat{s}_k(t)^2\right)^{\frac{1}{2}}$, où $\hat{s}_k$ est le premier signal virtuel de défaut ou deuxième signal virtuel de défaut correspondant, T est une durée de $\hat{s}_k$ et t est le temps.

7. Procédé de surveillance selon la revendication 1, dans lequel une signature parmi les signatures du premier ensemble de signatures ou du deuxième ensemble de signatures est une énergie calculée par : $\left(\sum_{t=1}^{T} \hat{s}_k(t)^2\right)$, où $\hat{s}_k$ est le premier signal virtuel de défaut ou deuxième signal virtuel de défaut correspondant, T est une durée de $\hat{s}_k$ et t est le temps.

8. Procédé de surveillance selon la revendication 1, comportant en outre une étape de calcul d'une sévérité $sev(def_A)$ du premier défaut et d'une sévérité $sev(def_B)$ du deuxième défaut.

9. Procédé de surveillance selon la revendication 8, dans lequel la sévérité $sev(def_k)$ du premier défaut ou du deuxième défaut est calculée à partir de la signature $\text{sign}_k$ du premier défaut ou deuxième défaut correspondant par :

$$\text{sev}(\text{def}_k) = \frac{|\text{sign}_k - \text{sign}_{k0}|}{|\text{sign}_{k0}|} \quad,$$

où $\text{sign}_{k0}$ est la valeur de la signature pour le premier défaut ou deuxième défaut correspondant au début d'une mise en service de l'équipement.

10. Procédé de surveillance selon la revendication 9, dans lequel la sévérité est calculée par un réseau de neurones ou une machine à vecteur de support ou un réseau bayésien.

11. Procédé de surveillance selon la revendication 1, dans lequel le premier défaut ou le deuxième défaut est un court-circuit d'un stator de moteur électrique.

12. Procédé de surveillance selon la revendication 1, dans lequel le premier défaut ou le deuxième défaut est un grippage d'une transmission mécanique.

**Patentansprüche**

1. Verfahren zum Überwachen einer Ausrüstung vom Typ elektromechanischer Aktor, wobei die Ausrüstung einen dreiphasigen Elektromotor umfasst, wobei das Überwachungsverfahren die Schritte umfasst:

   - Durchführen von Messungen von Dreiphasenströmen ($I_{a,b,c}$), die den dreiphasigen Elektromotor speisen;

   wobei das Verfahren durch die Schritte gekennzeichnet ist:

   - Projizieren der Dreiphasenstrommessungen in ein Park-Bezugssystem, um einen Quadraturstrom ($I_q$) zu erhalten;
   - Durchführen an dem Quadraturstrom einer Methode (30) einer Ensemble-empirischen Modenzerlegung, die mit einer Methode (40) zur Blindquellentrennung gekoppelt ist, um Quellkomponenten (IC1, ..., IC10) zu erhalten;
   - automatisches Auswählen (50) unter den Quellkomponenten eines ersten Satzes (52) von Quellkomponenten (IC1, ..., IC9), die empfindlich für einen ersten Fehler sind, und eines zweiten Satzes (53) von Quellkomponenten (IC10), die empfindlich für einen zweiten Fehler sind, indem ein Auswahlkriterium verwendet wird, wobei der erste Fehler und der zweite Fehler dazu imstande sind, den Betrieb der Ausrüstung zu verschlechtern;
   - Konstruieren (60) eines ersten virtuellen Fehlersignals $\hat{s}_{defA}$ anhand des ersten Satzes von Quellkomponenten und eines zweiten virtuellen Fehlersignals $\hat{s}_{defB}$ anhand des zweiten Satzes von Quellkomponenten;
   - Extrahieren (70) aus dem ersten virtuellen Fehlersignal eines ersten Satzes von Signaturen, die repräsentativ für den ersten Fehler sind, und aus dem zweiten virtuellen Fehlersignal eines zweiten Satzes von Signaturen, die repräsentativ für den zweiten Fehler sind.

2. Überwachungsverfahren nach Anspruch 1, bei dem die Methode der Blindquellentrennung eine Analyse unabhängiger Komponenten ist, die als Trennkriterium ein statistisches Unabhängigkeitskriterium verwendet.

3. Überwachungsverfahren nach Anspruch 1, bei dem die automatische Auswahl gemäß einem Auswahlkriterium erfolgt, das in Bezug auf den ersten Fehler und den zweiten Fehler ausgewählt wird und auf einer statistischen Charakteristik des ersten Satzes von Quellkomponenten und des zweiten Satzes von Quellkomponenten beruht.

4. Überwachungsverfahren nach Anspruch 3, bei dem die statistische Charakteristik eine Kurtosis ist.

5. Überwachungsverfahren nach Anspruch 1, bei dem die erste Signatur und/oder die zweite Signatur $\text{sign}_k$ derart ist, dass $\text{sign}_k = \text{NbPics}*\text{AmpCC}$, wobei NbPics eine Anzahl von Malen ist, wo das entsprechende erste virtuelle Fehlersignal oder zweite virtuelle Fehlersignal größer als ein vordefinierter Schwellenwert wird, und wobei AmpCC eine maximale Spitze-Spitze-Amplitude zwischen zwei Spitzen des entsprechenden ersten virtuellen Fehlersignals oder zweiten virtuellen Fehlersignals ist.

6. Überwachungsverfahren nach Anspruch 1, bei dem eine Signatur unter den Signaturen des ersten Signaturensatzes oder des zweiten Signaturensatzes ein wirksamer Wert ist, der berechnet wird durch: $(\sum_{t=1}^{T} \hat{s}_k(t)^2)^{1/2}$, wobei $\hat{s}_k$ das entsprechende erste virtuelle Fehlersignal oder zweite virtuelle Fehlersignal ist, T eine Dauer von $\hat{s}_k$ und t die Zeit ist.

7. Überwachungsverfahren nach Anspruch 1, bei dem eine Signatur unter den Signaturen des ersten Signaturensatzes oder des zweiten Signaturensatzes eine Energie ist, die berechnet wird durch: $(\sum_{t=1}^{T} \hat{s}_k(t)^2)$, wobei $\hat{s}_k$ das entsprechende erste virtuelle Fehlersignal oder zweite virtuelle Fehlersignal ist, T eine Dauer von $\hat{s}_k$ und t die Zeit ist.

8. Überwachungsverfahren nach Anspruch 1, ferner umfassend einen Schritt des Berechnens eines Schweregrades (sev(def$_A$) des ersten Fehlers und eines Schweregrades sev(def$_B$) des zweiten Fehlers.

9. Überwachungsverfahren nach Anspruch 8, bei dem der Schweregrad (sev(def$_k$) des ersten Fehlers oder des zweiten Fehlers anhand der Signatur sign$_k$ des entsprechenden ersten Fehlers oder zweiten Fehlers berechnet wird durch:

$$\mathrm{sev(def_k)} = \frac{|sign_k - sign_{k0}|}{|sign_{k0}|},$$

wobei sign$_{k0}$ der Wert der Signatur für den entsprechenden ersten Fehler oder zweiten Fehler zu Beginn einer Inbetriebnahme der Ausrüstung ist.

10. Überwachungsverfahren nach Anspruch 9, bei dem der Schweregrad durch ein neurales Netz oder eine Stützvektormaschine oder ein Bayessches Netz berechnet wird.

11. Überwachungsverfahren nach Anspruch 1, bei dem der erste Fehler oder der zweite Fehler ein Kurzschluss eines Stators des Elektromotors ist.

12. Überwachungsverfahren nach Anspruch 1, bei dem der erste Fehler oder der zweite Fehler ein Festfressen einer mechanischen Übertragung ist.

**Claims**

1. A monitoring method for monitoring equipment of electromechanical actuator type, the equipment including a three-phase electric motor, the monitoring method comprising the following steps:

   - measuring three-phase currents (I$_{a,b,c}$) powering the three-phase electric motor;

   the method being **characterized by** the steps:

   - projecting the three-phase currents into a Park reference frame in order to obtain a quadrature current (I$_q$) ;
   - performing an ensemblist empirical mode decomposition process (30) on the quadrature current coupled with a blind source separation process (40) in order to obtain source components (IC$_1$, ..., IC$_{10}$);
   - from among the source components, automatically selecting (50) a first set (52) of source components (IC$_1$,..., IC$_9$) sensitive to a first defect, and a second set (53) of source components (IC$_{10}$) sensitive to a second defect by using a selection criterion, the first defect and the second defect potentially degrading the operation of the equipment;
   - constructing (60) a first virtual defect signal $\hat{s}_{defA}$ from the first set of source components and a second virtual defect signal $\hat{s}_{defB}$ from the second set of source components; and
   - extracting (70) a first set of signatures representative of the first defect from the first virtual defect signal, and extracting (70) a second set of signatures representative of the second defect from the second virtual defect signal.

2. A monitoring method according to claim 1, wherein the blind source separation process comprises independent component analysis using as its separation criterion a statistical independence criterion.

3. A monitoring method according to claim 1, wherein the automatic selection is performed by using a selection criterion selected with reference to the first defect and to the second defect and based on a statistical characteristic of the first set of source components and of the second set of source components.

4. A monitoring method according to claim 3, wherein the statistical characteristic is a Kurtosis.

5. A monitoring method according to claim 1, wherein the first signature and/or the second signature $sign_k$ is such that $Sign_k$=NbPeaks*AmpPP, where NbPeaks is the number of times the corresponding first virtual defect signal or second virtual defect signal becomes greater than a predefined threshold, and where AmpPP is a maximum peak to peak amplitude between two peaks of the corresponding first virtual defect signal or second virtual defect signal.

6. A monitoring method according to claim 1, wherein a signature from among the signatures of the first set of signatures or of the second set of signatures is an rms value calculated using:

$$\left( \sum_{t=1}^{T} \hat{s}_k(t)^2 \right)^{\frac{1}{2}}$$

where $\hat{s}_k$ is the corresponding first virtual defect signal or the second virtual defect signal, T is the duration of $\hat{s}_k$, and $\underline{t}$ is time.

7. A monitoring method according to claim 1, wherein a signature from among the first set of signatures or the second set of signatures is an energy calculated using:

$$\left( \sum_{t=1}^{T} \hat{s}_k(t)^2 \right),$$

where $\hat{s}_k$ is the corresponding first virtual defect signal or second virtual defect signal, T is the duration of $\hat{s}_k$, and $\underline{t}$ is time.

8. A monitoring method according to claim 1, further comprising a step of calculating a severity $sev(def_A)$ for the first defect and a severity $sev(def_B)$ for the second defect.

9. A monitoring method according to claim 8, wherein the severity $sev(def_k)$ of the first defect or of the second defect is calculated from the signature $sign_k$ of the corresponding first defect or second defect as follows:

$$sev(def_k) = \frac{\left| sign_k - sign_{k0} \right|}{\left| sign_{k0} \right|}$$

where $sign_{k0}$ is the value of the signature for the corresponding first defect or second defect at the beginning of the equipment being put into service.

10. A monitoring method according to claim 9, wherein the severity is calculated by a neural network or by a vector support machine or by a Bayesian network.

11. A monitoring method according to claim 1, wherein the first defect or the second defect is a short circuit of an electric motor stator.

12. A monitoring method according to claim 1, wherein the first defect or the second defect is seizing of a mechanical transmission.

EP 3 593 154 B1

**Fig. 1**

**Fig. 2**

Fig. 3

Fig. 4

50

51 — $IC_1$ | $IC_2$ | $IC_3$ | $IC_4$ | ... | $IC_{10}$

52 — $IC_1$ | $IC_2$ | $IC_3$ | ... | $IC_9$ | 0

53 — 0 | 0 | 0 | ... | 0 | $IC_{10}$

ICA

IMF 1 à 10

EEMD

$I_q$

Multiplication par $W^{-1}$  — 61

Multiplication par $W^{-1}$  — 62

60

63 — $\sum$

$\sum$ — 64

$\widehat{S}_{def\,A}$

$\widehat{S}_{def\,B}$

70  71 — Calcul Signatures

Calcul Signatures — 72

$sign_{A1}$ : :

$sign_{B1}$ : :

80  82 — Calcul Sévérité

Calcul Sévérité — 83

$sev(def_A)$

$sev(def_B)$

Calcul de Sévérité

$sign_{A1}$ ... $sign_{B1}$ ...

Défaut A avec une sévérité X

Défaut B avec une sévérité Y

80

40

Observations IMF 1 à 10

Opérateur de Séparation

W — 41

$W = \operatorname*{argmax}_{IC}[\Phi]$

Sources Estimées

$IC_1$
$IC_2$
$IC_3$
⋮
$IC_{10}$

Critère de Séparation (Indépendance Statistique)

$\Phi$ — 42

**Fig. 5**

80

$sign_{A1}$
⋮
$sign_{AN}$

Outils d'automatique / d'intelligence artificielle

81

$sev(def_A)$

**Fig. 6**

**RÉFÉRENCES CITÉES DANS LA DESCRIPTION**

**Documents brevets cités dans la description**

- US 2015293177 A1, OTTEWILL JAMES